(19) **Europäisches Patentamt**

**European Patent Office**

**Office européen des brevets**

(11) **EP 1 069 688 A1**

(12) **EUROPÄISCHE PATENTANMELDUNG**

(43) Veröffentlichungstag:
**17.01.2001 Patentblatt 2001/03**

(51) Int. Cl.$^7$: **H03K 23/66**

(21) Anmeldenummer: **00111518.7**

(22) Anmeldetag: **29.05.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **30.06.1999 DE 19930168**

(71) Anmelder:
**Infineon Technologies AG**
**81541 München (DE)**

(72) Erfinder: **Heinen, Stefan, Dr.**
**47802 Krefeld (DE)**

(74) Vertreter:
**Fischer, Volker, Dipl.-Ing. et al**
**Epping Hermann & Fischer**
**Ridlerstrasse 55**
**80339 München (DE)**

(54) **Schaltungsanordnung für einen Frequenzteiler**

(57) Die Erfindung betrifft eine Schaltungsanordnung eines Frequenzteilers mit einem Vorteiler mit mindestens zwei unterschiedlichen Teilungsverhältnissen, an dessen Ausgang ein, bezüglich seines Teilungsverhältnisses M einstellbarer Hauptzähler (Main Counter) und ein untergeordneter erster, bezüglich seines Teilungsverhältnisses A1 einstellbarer Übertragszähler (swallow counter) vorgesehen ist, der den Vorteiler bezüglich seines Teilerverhältnisses umschalten kann, wobei der Vorteiler mindestens zwei weitere unterschiedliche Teilerverhältnisse aufweist und mindestens ein zweiter untergeordneter, bezüglich seines Teilungsverhältnisses A2 einstellbarer Übertragszähler am Ausgang des Vorzählers vorgesehen ist, der das Teilerverhältnis des Vorteilers zwischen den zwei weiteren Teilerverhältnissen umschalten kann.

Fig. 2

**Beschreibung**

Die Erfindung betrifft eine Schaltungsanordnung für einen Frequenzteiler mit einem Vorteiler mit mindestens vier unterschiedlichen Teilerverhältnissen, an dessen Ausgang ein bezüglich seines Teilungsverhältnisses M einstellbarer Hauptzähler (Main Counter) und ein untergeordneter erster bezüglich seines Teilungsverhältnisses A1 einstellbarer Übertragszähler (swallow counter) vorgesehen ist, der das Teilerverhältnis des Vorteilers umschalten kann.

Als nächstliegender Stand der Technik ist eine ähnliche Schaltungsanordnung aus der Offenlegungsschrift DE 197 00 017 A1 bekannt. In dieser Schrift wird allgemein eine PLL-Frequenz-Synthesizerschaltung beschrieben, die einen Vergleichs-Frequenzteiler enthält, welche mit einem „dual modulus"-Vorteiler und einem „swallow counter" ausgestattet ist, wobei die Schaltung eine Modulussignal-Ausgabesteuerung aufweist, die den „dual modulus"-Vorteiler steuert.

Ein Problem dieser bekannten Schaltungsanordnung besteht darin, daß bei der Verwendung des „dual modulus"-Prinzips für einen Synthesizer digitale Breitbandfunksysteme ein niedriges Vorteilerverhältnis erfordern, damit die benötigten Gesamtteilerverhältnisse realisiert werden können. Kleine Vorteilerverhältnisse bedingen jedoch bei diesem System große Hauptteilerverhältnisse, die zu einer hohen Arbeitsfrequenz des Hauptteilers und damit zu hoher Stromaufnahme und ungünstigen Systemeigenschaften, wie beispielsweise einem Phasenrauschen, führen.

Es ist daher Aufgabe der Erfindung, eine Schaltungsanordnung für einen Frequenzteiler zu finden, die zur Erreichung eines niedrigen Gesamtteilerverhältnisses N mit einem hohen Vorteilerverhältnis und einem niedrigen Hauptteilerverhältnis auskommt.

Die Aufgabe der Erfindung wird durch die Merkmale des Anspruches 1 gelöst.

Der Erfinder hat erkannt, daß sich zur Realisierung eines niedrigen Gesamtteilerverhältnisses N mit einem hohen Vorteilerverhältnis und gleichzeitig einem niedrigen Hauptteilerverhältnis die Möglichkeit besteht, anstelle eines einzigen Übertragszählers (swallow counter) eine Mehrzahl von Übertragszählern einsetzen lassen, die jeweils in Verbindung mit einem „dual modulus"-Teiler in einem mehrstelligen Zahlensystem hochzählen und dadurch mit an sich niedrigen einzelnen Teilerverhältnissen insgesamt ein hohes Gesamtteilerverhältnis generieren.

Demgemäß schlägt der Erfinder vor, die bekannte Schaltungsanordnung für einen Frequenzteiler mit einem Vorteiler (Prescaler) mit mindestens zwei unterschiedlichen Teilerverhältnissen, an dessen Ausgang ein, bezüglich seines Teilungsverhältnisses M einstellbarer Hauptzähler (Main Counter) und ein untergeordneter erster, bezüglich seines Teilungsverhältnisses A1 einstellbarer Übertragszähler (swallow counter) vorgesehen ist, der den Vorteiler bezüglich seines Teilerverhältnisses umschalten kann, dahingehend weiterzuentwickeln, daß der Vorteiler mindestens zwei weitere unterschiedliche Teilerverhältnisse aufweist und mindestens ein zweiter untergeordneter, bezüglich seines Teilungsverhältnisses A2 einstellbarer Übertragszähler (swallow counter) am Ausgang des Vorzählers vorgesehen ist, der das Teilerverhältnis des Vorteilers zwischen den zwei weiteren Teilerverhältnissen umschalten kann.

Vorteilhaft kann der Vorteiler aus zwei „dual modulus"-Teilern bestehen, die über die Übertragszähler zumindest sowohl zwischen den Teilerverhältnissen $K_1$ und $K_1+1$ als auch $K_2$ und $K_2+1$ umschaltbar sind, wobei für die Umschaltung des Teilerverhältnisses $K_1$ auf $K_1+1$ des ersten „dual modulus"-Teilers ein erster Umschalteingang (mc) und für die Umschaltung des Teilerverhältnisses $K_2$ auf $K_2+1$ des zweiten „dual modulus"-Teilers ein zweiter Eingang vorgesehen ist, und wobei weiterhin eine zusätzliche Schaltung zwischen den zwei „dual modulus"-Teilern besteht, die bewirkt, daß innerhalb eines Zähldurchlaufes des zweiten „dual modulus"-Teilers eine Umschaltung des ersten „dual modulus"-Teilers auf das höhere Teilerverhältnis $K_1+1$ nur einmal stattfindet.

Die genannten Teilerverhältnisse K1 und K2 sind in der Regel Zahlen, die sich aus Potenzen zur Basis 2 errechnen, wobei $K1=2^{P0}$ und $K2=2^{P1}$. Für das Gesamtteilerverhältnis des Vorteilers (Prescaler-Teilerverhältnis) $P_{ges}$ gilt:

$$P_{ges} = 2^{P0} * 2^{P1} + 2^{P1} * mc_1 + mc_0 ,$$

wobei P0 der Exponent zu 2 des Teilerverhältnisses des ersten „dual modulus"-Teilers, P1 der Exponent zu 2 des Teilerverhältnisses des zweiten „dual modulus"-Teilers ist und mc0 und mc1 der Wertigkeit 0 oder 1 der Umschalteingänge (mc) des jeweiligen „dual modulus"-Teilers entspricht. Für die Exponenten P0 und P1 gilt vorteilhaft $P1 \leq P0$ und vorzugsweise $2^{P1} = 2^{P0}$. Somit ergeben sich aus der Variation der Werte mc0 und mc1 die möglichen Prescaler-Teilerverhältnisse zu:

$$P_{ges} = 2^{(P0+P1)} + 2^{P1} * 0 + 0,$$

$$P_{ges} = 2^{(P0+P1)} + 2^{P1} * 0 + 1,$$

$$P_{ges} = 2^{(P0+P1)} + 2^{P1} * 1 + 0, \text{ und}$$

$$P_{ges} = 2^{(P0+P1)} + 2^{P1} * 1 + 1.$$

Wird also beispielsweise als erster „dual modulus"-Teiler ein 16/17-Teiler und als zweiter „dual modulus"-Teiler ein 4/5-Teiler eingesetzt, so ergeben sich für den „quadro modulus"-Teiler die folgenden, möglichen Prescaler-Teilerverhältnisse:

$$P_{ges} = 2^{2+4} + 2^4 * 0 + 0 = 64,$$

$$P_{ges} = 2^{2+4} + 2^4 * 0 + 1 = 65,$$

$$P_{ges} = 2^{2+4} + 2^4 * 1 + 0 = 80, \text{ und}$$

$$P_{ges} = 2^{2+4} + 2^4 * 1 + 1 = 81.$$

Weiterhin kann der Hauptzähler (Main Counter) derart ausgestaltet sein, daß er nach dem Eingang vom M voreingestellten Impulsen einen Ausgangsimpuls ausgibt und sich selbständig wieder auf einen vorgegebenen Anfangswert zurücksetzt.

Außerdem kann vorteilhaft der Eingang des ersten einstellbaren Übertragszählers (swallow counter) mit dem Ausgang des Vorteilers (Prescaler) und der Ausgang des Übertragszählers mit dem niederwertigen Umschalteingang des „quadro modulus"-Vorteilers (=Umschalteingang des ersten „dual modulus"-Teilers) verbunden sein, wobei der Ladeimpuls des Hauptzählers auch den ersten Übertragszähler zurücksetzt und weiterhin der Eingang des zweiten einstellbaren Übertragszählers (swallow counter) mit dem Ausgang des Vorteilers und der Ausgang des zweiten Übertragszählers mit dem höherwertigen Umschalteingang des „quadro modulus"-Vorteilers (=Umschalteingang des zweiten „dual modulus"-Teilers) verbunden sein kann, wobei der Ladeimpuls des Hauptzählers auch den zweiten Übertragszähler zurücksetzt.

Durch diese Schaltungsanordnung wird ein Gesamtteilerverhältnis N der gesamten Schaltungsanordnung von $N = (K_1 * K_2) * M + K_2 * A2 + A1$ erreicht. Durch eine geschickte Auswahl der einzelnen Teilerverhältnisse läßt sich mit Hilfe von an sich kleinen einzelnen Teilerverhältnissen leicht ein insgesamt großes Teilerverhältnis realisieren. Im Grunde entspricht diese Art der Teilerbildung der „Schreibweise" einer hohen Zahl in einem Zahlensystem mit wenigen Basiszahlen durch Nutzung mehrerer „Stellen". Hierbei sind aufgrund der Schaltungsanordnung aber erst ab einem bestimmten Wert $N_1$ alle Gesamtteilerverhältnisse in 1-er-Schritten definierbar.

Eine vorteilhafte konkrete Ausführung der Schaltungsanordnung sieht vor, daß der erste „dual modulus"-Teiler ein 16/17-Teiler und der zweite „dual modulus"-Teiler ein 4/5-Teiler ist und beide einen „quadro modulus"-Vorteiler mit den Teilerverhältnissen 64/65/80/81 bilden. Hierdurch ergibt sich ein Gesamtteilerverhältnis N=64*M+16*A2+A1 . Mit $0 \leq A1, A2 \leq M$ können ab $M \geq 15$ alle ganzzahligen Gesamtteilerverhältnisse $N \geq 960$ lückenlos durch Variation der M, A1 und A2 - Werte angewählt werden.

Eine andere vorteilhafte konkrete Ausführung der Schaltungsanordnung sieht vor, daß der erste und der zweite „dual modulus"-Teiler jeweils ein 8/9-Teiler ist und beide einen „quadro modulus"-Vorteiler mit den Teilerverhältnissen 64/65/72/73 bilden.

Für eine weitere vorteilhafte Ausführung der Schaltungsanordnung kann vorgesehen werden, daß der erste und der zweite „dual modulus"-Teiler jeweils ein 16/17-Teiler ist und beide einen „quadro modulus"-Vorteiler mit den Teilerverhältnissen 256/257/272/273 bilden.

Eine nochmals weitere vorteilhafte Ausführung der Schaltungsanordnung kann vorsehen, daß das Teilerverhältnis $K_1$ des ersten „dual modulus"-Teilers gleich dem Teilerverhältnis $K_2$ des zweiten „dual modulus"-Teilers ist. Hierdurch werden Redundanzen in der Numerierung des Teilers vermieden.

Zur Verwirklichung eines besonders niedrigen Gesamtteilerverhältnisses N mit möglichst hohem Vorteilerverhältnissen ist es vorteilhaft, wenn der Vorteiler weitere verschaltete „dual modulus"-Teiler aufweist und weitere Übertragszähler vorgesehen sind, wobei jedem der „dual modulus"-Teiler ein Übertragszähler zugeordnet ist und wobei weiterhin eine zusätzliche Schaltung zwischen den „dual modulus"-Teilern besteht, die bewirkt, daß innerhalb eines Zähldurchlaufes des weiteren „dual modulus"-Teilers eine Umschaltung der anderen „dual modulus"-Teiler auf das höhere Teilerverhältnis nur einmal stattfindet. Hiermit kann durch Verwendung eines „mehrstelligen" Gesamtteilers durch eine geringe Anzahl niedriger „dual modulus"-Teiler ein entsprechend hohes Gesamtteilerverhältnis N erreicht werden.

Erfindungsgemäß können die dargestellten Schaltungsanordnungen in einer „Phase Locked Loop" (PLL) - Schaltung als Frequenzteiler eingebunden werden. Besonders bevorzugt kann diese erfindungsgemäße PLL-Schaltung dann in einem Mobilfunksystem eingesetzt werden, wobei sich erhebliche Stromeinsparungen gegenüber dem Stand der Technik ergeben, wodurch wiederum auch eine Verkleinerung der benutzten Stromquellen (Akkus) ohne Reduktion der zur Verfügung stehenden Betriebszeit möglich ist.

Es versteht sich, daß die vorstehend genannten und nachstehend noch zu erläuternden Merkmale der Erfindung nicht nur in der jeweils angegebenen Kombination, sondern auch in anderen Kombinationen oder in Alleinstellung verwendbar sind, ohne den Rahmen der Erfindung zu verlassen.

Zusätzliche Merkmale und Vorteile der Erfindung ergeben sich aus der nachfolgenden Beschreibung bevorzugter Ausführungsbeispiele unter Bezugnahme auf die Zeichnungen.

Die Erfindung soll nachfolgend anhand der Zeichnungen näher erläutert werden. Es stellen dar:

Figur 1: „quadro modulus"-Prescaler 64/65/80/81;
Figur 2: Erfindungsgemäßer Frequenzzähler;
Figur 3: Beispiel eines Zählvorgangs mit 16/17- und 4/5-Teiler;
Figur 4: „quadro modulus"-Prescaler 64/65/72/73;
Figur 5: Beispiel eines Zählvorgangs mit zwei 8/9-Teilern.

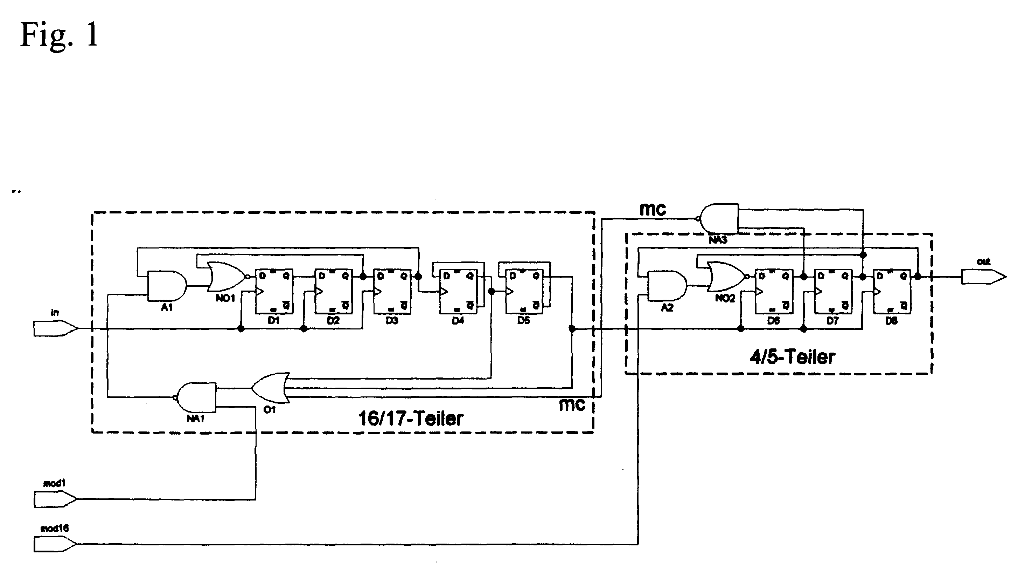

Die Figur 1 zeigt einen beispielhaften „quadro modulus"- Vorteiler, wie er in der erfindungsgemäßen Schaltung eingesetzt werden kann. Der „quadro modulus"-Vorteiler besteht aus zwei kaskadierten „dual modulus"-Teilern. Beim ersten Teiler handelt es sich um einen standardmäßigen 16/17-Teiler, der mit einem zusätzlichen Steuereingang MC ausgestattet ist, welcher eine Verriegelung des 17er Teilerverhältnisses bewirken kann. Der Ausgang des ersten Vorteilers ist mit dem Eingang des zweiten „dual modulus"-Teilers, einem 4/5-Teiler, verbunden, der über ein NAND-Gatter NA3 aus den internen Signalen das Steuersignal MC generiert, welches genau einmal in der Gesamtperiode die Umschaltung des ersten Teilers in einer Gesamtzählperiode in den 17er-Modus erlaubt. Eine Umschaltung des zweiten Teilers vom Teilerverhältnis 4 zum Teilerverhältnis 5 erhöht also das Gesamtteilerverhältnis des dargestellten „quadro modulus"-Prescalers um 16, wobei dies unabhängig vom Status des ersten Teilers geschieht.

Somit kann durch die dargestellte Schaltung der zwei kaskadierten „dual modulus"-Teiler ein „quadro modulus"-Teiler mit einem einstellbaren Teilerverhältnis von 64, 65, 80 und 81 erreicht werden.

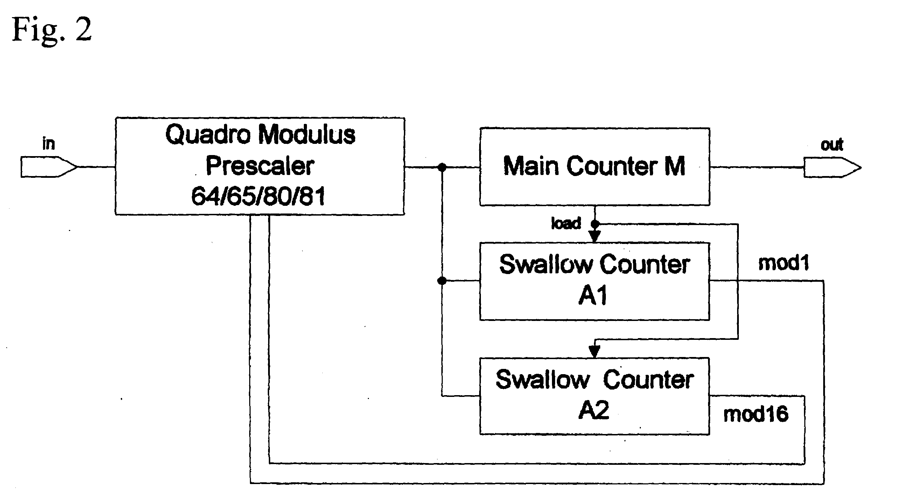

Wird dieser in der Figur 1 beschriebene „quadro modulus"-Prescaler in der in Figur 2 gezeigten Weise mit einem Hauptzähler und zwei Übertragszählern verschaltet, wobei jedem Übertragszähler die Umschaltung eines „dual modulus"-Vorteilers von einem Teilermodus zu einem weiteren Teilermodus möglich ist, so kann ab einem bestimmten Teilerverhältnis M des Hauptzählers durch sinnvolle Einstellung der Teilerverhältnisse des Hauptzählers und der beiden Übertragszähler lückenlos jedes Gesamtteilerverhältnis N erreicht werden.

Die gesamte Schaltungsanordnung erzeugt in Abhängigkeit der Einstellungen der Teilerverhältnisse M des Hauptzählers, A1 des ersten Übertragszählers und A2 des zweiten Übertragszählers ein Gesamtteilerverhältnis N mit $N=64*M + 16*A2 + A1$ mit A1, A2 $\leq$ M. Hier können also ab einem Wert M=15 beziehungsweise N=960 alle Gesamtteilerverhältnisse größer gleich 960 in 1-er-Schritten generiert werden.

Betrachtet man hiergegen das bekannte „dual modulus"-Prinzip, so wären bei einem 64/65-Vorteiler erst ab einem Hauptteilerverhältnis N=4032, entsprechend einem M=64-1, alle Gesamtteilerverhältnisse einstellbar. Die erfindungsgemäße Schaltungsanordnung erreicht also, daß bei gleicher Größe des maximalen Vorteilerverhältnisses ein geringeres Hauptteilerverhältnis M notwendig ist um das Gesamtteilerverhältnis durchzählbar einzustellen.

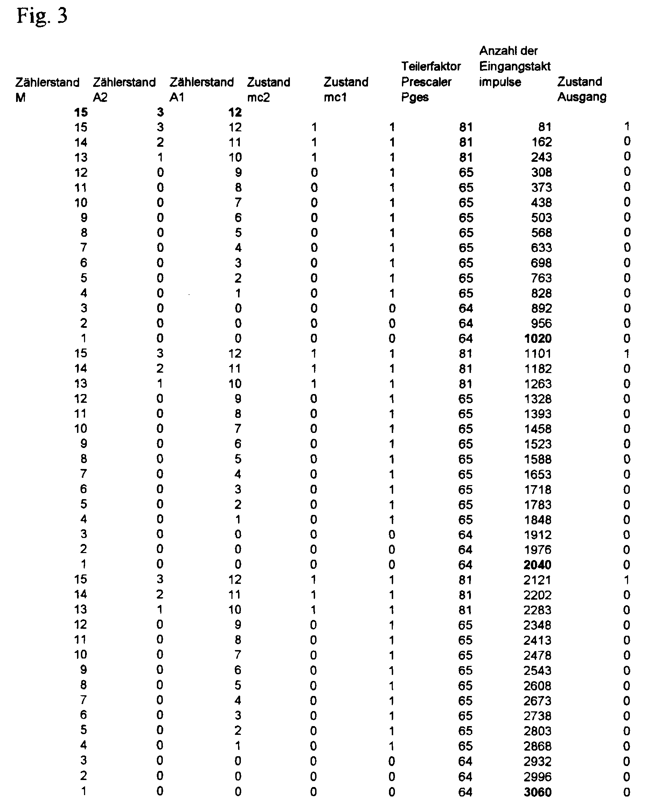

In der Figur 3 ist anhand einer Tabelle der Zählstatus der erfindungsgemäßen Schaltungsanordnung aus Figur 2 mit einem Zähler gemäß Figur 1 dargestellt.

In der fettgedruckten Zeile 2 sind die Anfangswerte der einzelnen Teiler angegeben. Der Zählstart, also die Gesamtperiode, beginnt mit der nachfolgenden Zeile, in der an allen Zählern die eingestellten Anfangswerte aus der fettgedruckten Zeile anliegen.

Die Tabelle zeigt in der ersten Spalte die Zählerstände des Hauptzählers M, in der zweiten und dritte Spalte die Zählerstände der Übertragszähler A2 und A1. Die vierte und fünfte Spalte gibt die Zustände der Moduluskontroll-Eingänge mc1 und mc0 des zweiten und ersten „dual modulus"-Teilers wieder. Die fünfte Spalte zeigt das je Zeile aktuelle Teilerverhältnis des Vorteilers an, wobei die vorletzte Spalte die Anzahl der insgesamt eingegangenen Impulse darstellt. Schließlich ist in der letzten Spalte der Zustand des Ausganges an der erfindungsgemäßen Zählerschaltung dargestellt.

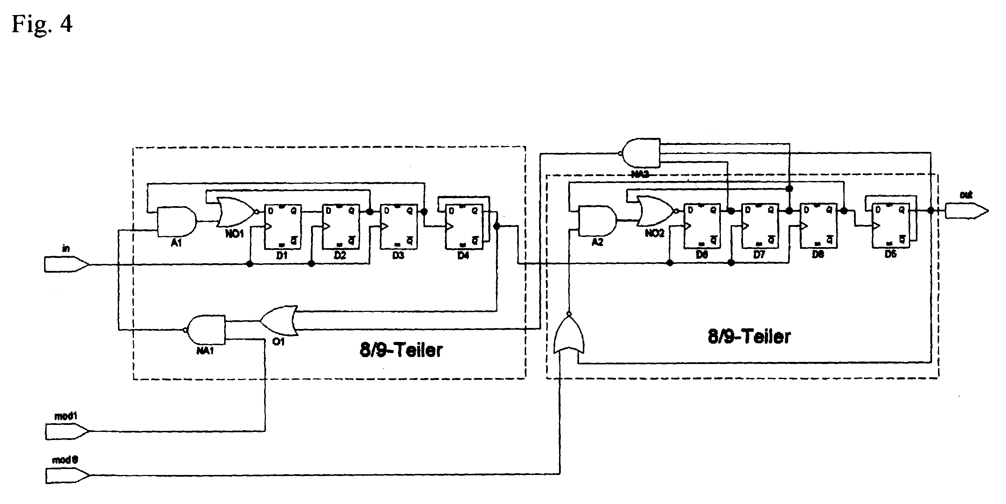

Die Figur 4 zeigt eine weitere Variante eines „quadro modulus"-Prescalers mit Teilerverhältnissen 64/65/72/73, der aus zwei kaskadierten 8/9-Teilern gebildet wird. Durch die Wahl dieser Teiler wird das Gesamtteilerverhältnis berechnet mit: $M=64*M + 8*A2 + A1$ mit A1, A2 $\leq$ M. Hierdurch wird ab einem M $\geq$ 7 beziehungsweise N $\geq$ 448 es ermöglicht, alle Teilerverhältnisse lückenlos zu generieren.

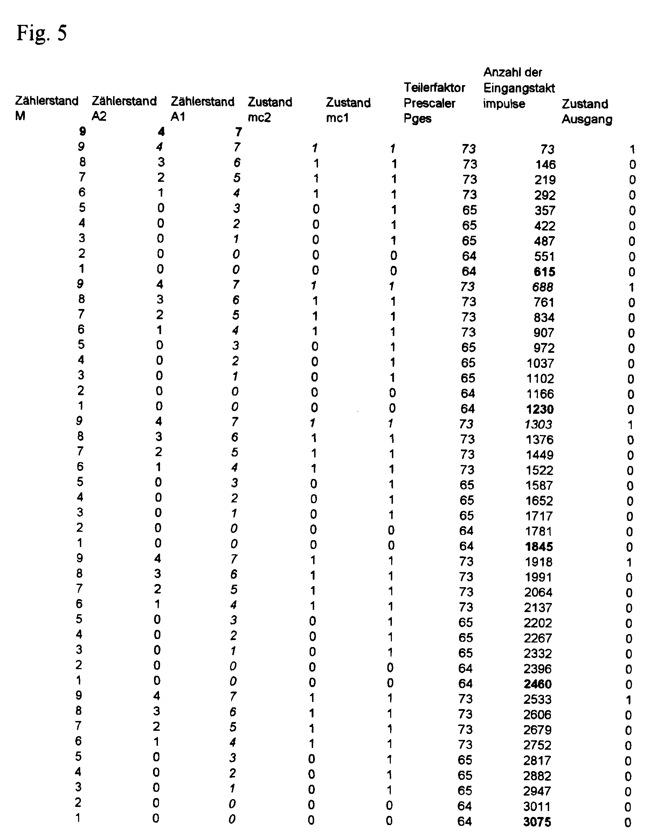

Eine der Tabelle aus Figur 3 entsprechende Darstellung des Zählerverhaltens ist in der Figur 5 auf die Anwendung des Prescalers aus Figur 4 dargestellt. In dieser Darstellung liegen die Vorgabewerte des Hauptzählers bei M=9, des ersten Übertragszählers bei A1=7 und des zweiten Übertragszählers bei A2=4, wobei zwei kaskadierte 8/9-Teiler verwendet werden. Entsprechend den Vorgabewerten wird ein Gesamtteilerverhältnis N=615 erreicht und die Schaltung gibt alle 615 Eingangsimpulse einen Ausgangsimpuls aus.

Mit der erfindungsgemäßen Schaltungsanordnung wird also ein Frequenzteiler vorgestellt, der zur Erreichung eines niedrigen Gesamtteilerverhältnisses N mit einem hohen Vorteilerverhältnis und einem niedrigen Hauptteilerverhältnis auskommt.

**Patentansprüche**

1.    Schaltungsanordnung für einen Frequenzteiler mit: einem Vorteiler (Prescaler) mit mindestens zwei unterschiedlichen Teilerverhältnissen, an dessen Ausgang ein, bezüglich seines Teilungsverhältnisses M einstellbarer Hauptzähler (Main Counter) und ein untergeordneter erster, bezüglich seines Teilungsverhältnisses A1 einstellbarer Übertragszähler (swallow counter) vorgesehen ist, der den Vorteiler bezüglich seines Teilerverhältnisses umschalten kann, **dadurch gekennzeichnet**, daß der Vorteiler mindestens zwei weitere unterschiedliche Teilerverhältnisse aufweist und mindestens ein zweiter untergeordneter, bezüglich seines Teilungsverhältnisses A2 einstellbarer Übertragszähler (swallow counter) am Ausgang des Vorzählers vorgesehen ist, der das Teilerverhältnis des Vorteilers zwischen den zwei weiteren Teilerverhältnissen umschalten kann.

**2.** Schaltungsanordnung gemäß Anspruch 1, **dadurch gekennzeichnet**, daß der Vorteiler aus zwei „dual modulus"-Teilern besteht, die über die Übertragszähler zumindest sowohl zwischen den Teilerverhältnissen $K_1$ und $K_1+1$ als auch $K_2$ und $K_2+1$ umschaltbar sind, wobei für die Umschaltung des Teilerverhältnisses $K_1$ auf $K_1+1$ des ersten „dual modulus"-Teilers ein erster Umschalteingang und für die Umschaltung des Teilerverhältnisses $K_2$ auf $K_2+1$ des zweiten „dual modulus"-Teilers ein zweiter Eingang vorgesehen ist, wobei eine zusätzliche Schaltung zwischen den zwei „dual modulus"-Teilern besteht, die bewirkt, daß innerhalb eines Zähldurchlaufes des zweiten „dual modulus"-Teilers eine Umschaltung des ersten „dual modulus"-Teilers auf das höhere Teilerverhältnis $K_1+1$ nur einmal stattfindet.

**3.** Schaltungsanordnung gemäß einem der voranstehenden Ansprüche 1 bis 2, **dadurch gekennzeichnet**, daß der Hauptzähler (Main Counter) nach dem Eingang der voreingestellten M Impulse einen Ausgangsimpuls und einen Ladeimpuls abgibt und damit sich wieder auf einen Anfangswert zurücksetzt.

**4.** Schaltungsanordnung gemäß einem der voranstehenden Ansprüche 1 bis 3, **dadurch gekennzeichnet**, daß, der Eingang des ersten Übertragszähler (swallow counter) mit dem Ausgang des Vorzählers und dessen Ausgang mit dem ersten Umschalteingang des ersten „dual modulus"-Teilers des Vorzählers verbunden ist, wobei der Ladeimpuls des Hauptzählers auch den ersten Übertragszähler zurücksetzt.

**5.** Schaltungsanordnung gemäß einem der voranstehenden Ansprüche 1 bis 4, **dadurch gekennzeichnet**, daß, der Eingang des zweiten einstellbaren Übertragszähler (swallow counter) mit dem Ausgang des Vorzählers und dessen Ausgang mit dem ersten Umschalteingang des zweiten „dual modulus"-Teilers des Vorzählers verbunden ist, wobei der Ladeimpuls des Hauptzählers auch den zweiten Übertragszähler zurücksetzt.

**6.** Schaltungsanordnung gemäß einem der voranstehenden Ansprüche 1 bis 5, **dadurch gekennzeichnet**, daß der erste „dual modulus"-Teiler ein 16/17-Teiler und der zweite „dual modulus"-Teiler ein 4/5-Teiler ist und beide einen „quadro modulus"-Vorteiler mit den Teilerverhältnissen 64/65/80/81 bilden.

**7.** Schaltungsanordnung gemäß einem der voranstehenden Ansprüche 1 bis 5, **dadurch gekennzeichnet**, daß der erste und der zweite „dual modulus"-Teiler jeweils ein 8/9-Teiler ist und beide einen „quadro modulus"-Vorteiler mit den Teilerverhältnissen 64/65/72/73 bilden.

**8.** Schaltungsanordnung gemäß einem der voranstehenden Ansprüche 1 bis 5, **dadurch gekennzeichnet**, daß der erste und der zweite „dual modulus"-Teiler jeweils ein 16/17-Teiler ist und beide einen „quadro modulus"-Vorteiler mit den Teilerverhältnissen 256/257/272/273 bilden.

**9.** Schaltungsanordnung gemäß einem der voranstehenden Ansprüche 1 bis 5, **dadurch gekennzeichnet**, daß für das Teilerverhältnis $K_1$ dem Quadrat des Teilerverhältnis $K_2$ entspricht.

**10.** Schaltungsanordnung gemäß einem der voranstehenden Ansprüche 1 bis 9, **dadurch gekennzeichnet**, daß der Vorteiler weitere verschaltete „dual modulus"-Teiler aufweist und weitere Übertragszähler vorgesehen sind, wobei jedem der „dual modulus"-Teiler ein Übertragszähler zugeordnet ist und wobei weiterhin eine zusätzliche Schaltung zwischen den „dual modulus"-Teilern besteht, die bewirkt, daß innerhalb eines Zähldurchlaufes des weiteren „dual modulus"-Teilers eine Umschaltung der anderen „dual modulus"-Teiler auf das höhere Teilerverhältnis nur einmal stattfindet.

**11.** Schaltungsanordnung gemäß einem der voranstehenden Ansprüche 1 bis 10, **dadurch gekennzeichnet**, daß sie in einer „Phase Locked Loop" (PLL) - Schaltung als Frequenzteiler eingebunden ist.

**12.** Schaltungsanordnung gemäß einem der voranstehenden Ansprüche 1 bis 11, **dadurch gekennzeichnet**, daß sie in einem Mobilfunksystem zur Bildung einer Referenzfrequenz eingebunden ist.

Fig. 1

# Fig. 2

EP 1 069 688 A1

# Fig. 3

| Zählerstand M | Zählerstand A2 | Zählerstand A1 | Zustand mc2 | Zustand mc1 | Teilerfaktor Prescaler Pges | Anzahl der Eingangstakt impulse | Zustand Ausgang |
|---|---|---|---|---|---|---|---|
| **15** | **3** | **12** | | | | | |
| 15 | 3 | 12 | 1 | 1 | 81 | 81 | 1 |
| 14 | 2 | 11 | 1 | 1 | 81 | 162 | 0 |
| 13 | 1 | 10 | 1 | 1 | 81 | 243 | 0 |
| 12 | 0 | 9 | 0 | 1 | 65 | 308 | 0 |
| 11 | 0 | 8 | 0 | 1 | 65 | 373 | 0 |
| 10 | 0 | 7 | 0 | 1 | 65 | 438 | 0 |
| 9 | 0 | 6 | 0 | 1 | 65 | 503 | 0 |
| 8 | 0 | 5 | 0 | 1 | 65 | 568 | 0 |
| 7 | 0 | 4 | 0 | 1 | 65 | 633 | 0 |
| 6 | 0 | 3 | 0 | 1 | 65 | 698 | 0 |
| 5 | 0 | 2 | 0 | 1 | 65 | 763 | 0 |
| 4 | 0 | 1 | 0 | 1 | 65 | 828 | 0 |
| 3 | 0 | 0 | 0 | 0 | 64 | 892 | 0 |
| 2 | 0 | 0 | 0 | 0 | 64 | 956 | 0 |
| 1 | 0 | 0 | 0 | 0 | 64 | **1020** | 0 |
| 15 | 3 | 12 | 1 | 1 | 81 | 1101 | 1 |
| 14 | 2 | 11 | 1 | 1 | 81 | 1182 | 0 |
| 13 | 1 | 10 | 1 | 1 | 81 | 1263 | 0 |
| 12 | 0 | 9 | 0 | 1 | 65 | 1328 | 0 |
| 11 | 0 | 8 | 0 | 1 | 65 | 1393 | 0 |
| 10 | 0 | 7 | 0 | 1 | 65 | 1458 | 0 |
| 9 | 0 | 6 | 0 | 1 | 65 | 1523 | 0 |
| 8 | 0 | 5 | 0 | 1 | 65 | 1588 | 0 |
| 7 | 0 | 4 | 0 | 1 | 65 | 1653 | 0 |
| 6 | 0 | 3 | 0 | 1 | 65 | 1718 | 0 |
| 5 | 0 | 2 | 0 | 1 | 65 | 1783 | 0 |
| 4 | 0 | 1 | 0 | 1 | 65 | 1848 | 0 |
| 3 | 0 | 0 | 0 | 0 | 64 | 1912 | 0 |
| 2 | 0 | 0 | 0 | 0 | 64 | 1976 | 0 |
| 1 | 0 | 0 | 0 | 0 | 64 | **2040** | 0 |
| 15 | 3 | 12 | 1 | 1 | 81 | 2121 | 1 |
| 14 | 2 | 11 | 1 | 1 | 81 | 2202 | 0 |
| 13 | 1 | 10 | 1 | 1 | 81 | 2283 | 0 |
| 12 | 0 | 9 | 0 | 1 | 65 | 2348 | 0 |
| 11 | 0 | 8 | 0 | 1 | 65 | 2413 | 0 |
| 10 | 0 | 7 | 0 | 1 | 65 | 2478 | 0 |
| 9 | 0 | 6 | 0 | 1 | 65 | 2543 | 0 |
| 8 | 0 | 5 | 0 | 1 | 65 | 2608 | 0 |
| 7 | 0 | 4 | 0 | 1 | 65 | 2673 | 0 |
| 6 | 0 | 3 | 0 | 1 | 65 | 2738 | 0 |
| 5 | 0 | 2 | 0 | 1 | 65 | 2803 | 0 |
| 4 | 0 | 1 | 0 | 1 | 65 | 2868 | 0 |
| 3 | 0 | 0 | 0 | 0 | 64 | 2932 | 0 |
| 2 | 0 | 0 | 0 | 0 | 64 | 2996 | 0 |
| 1 | 0 | 0 | 0 | 0 | 64 | **3060** | 0 |

Fig. 4

8/9-Teiler

8/9-Teiler

EP 1 069 688 A1

# Fig. 5

| Zählerstand M | Zählerstand A2 | Zählerstand A1 | Zustand mc2 | Zustand mc1 | Teilerfaktor Prescaler Pges | Anzahl der Eingangstakt impulse | Zustand Ausgang |
|---|---|---|---|---|---|---|---|
| 9 | 4 | 7 | | | | | |
| 9 | 4 | 7 | 1 | 1 | 73 | 73 | 1 |
| 8 | 3 | 6 | 1 | 1 | 73 | 146 | 0 |
| 7 | 2 | 5 | 1 | 1 | 73 | 219 | 0 |
| 6 | 1 | 4 | 1 | 1 | 73 | 292 | 0 |
| 5 | 0 | 3 | 0 | 1 | 65 | 357 | 0 |
| 4 | 0 | 2 | 0 | 1 | 65 | 422 | 0 |
| 3 | 0 | 1 | 0 | 1 | 65 | 487 | 0 |
| 2 | 0 | 0 | 0 | 0 | 64 | 551 | 0 |
| 1 | 0 | 0 | 0 | 0 | 64 | 615 | 0 |
| 9 | 4 | 7 | 1 | 1 | 73 | 688 | 1 |
| 8 | 3 | 6 | 1 | 1 | 73 | 761 | 0 |
| 7 | 2 | 5 | 1 | 1 | 73 | 834 | 0 |
| 6 | 1 | 4 | 1 | 1 | 73 | 907 | 0 |
| 5 | 0 | 3 | 0 | 1 | 65 | 972 | 0 |
| 4 | 0 | 2 | 0 | 1 | 65 | 1037 | 0 |
| 3 | 0 | 1 | 0 | 1 | 65 | 1102 | 0 |
| 2 | 0 | 0 | 0 | 0 | 64 | 1166 | 0 |
| 1 | 0 | 0 | 0 | 0 | 64 | 1230 | 0 |
| 9 | 4 | 7 | 1 | 1 | 73 | 1303 | 1 |
| 8 | 3 | 6 | 1 | 1 | 73 | 1376 | 0 |
| 7 | 2 | 5 | 1 | 1 | 73 | 1449 | 0 |
| 6 | 1 | 4 | 1 | 1 | 73 | 1522 | 0 |
| 5 | 0 | 3 | 0 | 1 | 65 | 1587 | 0 |
| 4 | 0 | 2 | 0 | 1 | 65 | 1652 | 0 |
| 3 | 0 | 1 | 0 | 1 | 65 | 1717 | 0 |
| 2 | 0 | 0 | 0 | 0 | 64 | 1781 | 0 |
| 1 | 0 | 0 | 0 | 0 | 64 | 1845 | 0 |
| 9 | 4 | 7 | 1 | 1 | 73 | 1918 | 1 |
| 8 | 3 | 6 | 1 | 1 | 73 | 1991 | 0 |
| 7 | 2 | 5 | 1 | 1 | 73 | 2064 | 0 |
| 6 | 1 | 4 | 1 | 1 | 73 | 2137 | 0 |
| 5 | 0 | 3 | 0 | 1 | 65 | 2202 | 0 |
| 4 | 0 | 2 | 0 | 1 | 65 | 2267 | 0 |
| 3 | 0 | 1 | 0 | 1 | 65 | 2332 | 0 |
| 2 | 0 | 0 | 0 | 0 | 64 | 2396 | 0 |
| 1 | 0 | 0 | 0 | 0 | 64 | 2460 | 0 |
| 9 | 4 | 7 | 1 | 1 | 73 | 2533 | 1 |
| 8 | 3 | 6 | 1 | 1 | 73 | 2606 | 0 |
| 7 | 2 | 5 | 1 | 1 | 73 | 2679 | 0 |
| 6 | 1 | 4 | 1 | 1 | 73 | 2752 | 0 |
| 5 | 0 | 3 | 0 | 1 | 65 | 2817 | 0 |
| 4 | 0 | 2 | 0 | 1 | 65 | 2882 | 0 |
| 3 | 0 | 1 | 0 | 1 | 65 | 2947 | 0 |
| 2 | 0 | 0 | 0 | 0 | 64 | 3011 | 0 |
| 1 | 0 | 0 | 0 | 0 | 64 | 3075 | 0 |

Europäisches
Patentamt

**EUROPÄISCHER RECHERCHENBERICHT**

Nummer der Anmeldung

EP 00 11 1518

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| Y<br><br>A<br><br>Y | EP 0 171 162 A (FLUKE MFG CO JOHN)<br>12. Februar 1986 (1986-02-12)<br>* Seite 4, Zeile 13 - Seite 18, Zeile 7;<br>Abbildungen 1-3 *<br>---<br>WO 81 02371 A (MOTOROLA INC)<br>20. August 1981 (1981-08-20)<br>* Seite 6, Zeile 2 - Seite 13, Zeile 35 *<br>----- | 1,2,<br>10-12<br>3<br><br>1,2,<br>10-12 | H03K23/66 |

**RECHERCHIERTE SACHGEBIETE (Int.Cl.7)**

H03K

Der vorliegende Recherchenbericht wurde für alle Patentansprüche erstellt

| Recherchenort | Abschlußdatum der Recherche | Prüfer |
|---|---|---|
| DEN HAAG | 3. Oktober 2000 | Feuer, F |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument

......................................................................
& : Mitglied der gleichen Patentfamilie, übereinstimmendes
  Dokument

## ANHANG ZUM EUROPÄISCHEN RECHERCHENBERICHT
## ÜBER DIE EUROPÄISCHE PATENTANMELDUNG NR.

EP 00 11 1518

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-10-2000

| Im Recherchenbericht angeführtes Patentdokument | Datum der Veröffentlichung | Mitglied(er) der Patentfamilie | | Datum der Veröffentlichung |
|---|---|---|---|---|
| EP 0171162 A | 12-02-1986 | US | 4573023 A | 25-02-1986 |
| | | JP | 61105120 A | 23-05-1986 |
| WO 8102371 A | 20-08-1981 | US | 4316151 A | 16-02-1982 |
| | | AU | 534342 B | 19-01-1984 |
| | | AU | 7037181 A | 31-08-1981 |
| | | BR | 8106699 A | 22-12-1981 |
| | | CA | 1150371 A | 19-07-1983 |
| | | EP | 0045799 A | 17-02-1982 |
| | | JP | 2055976 B | 28-11-1990 |
| | | JP | 57500134 T | 21-01-1982 |

EPO FORM P0461

Für nähere Einzelheiten zu diesem Anhang : siehe Amtsblatt des Europäischen Patentamts, Nr.12/82